# FASCICULE DE BREVET EUROPEEN

(11) **EP 3 237 324 B1**
(45) Date de publication et mention de la délivrance du brevet: **18.05.2022**
(21) Numéro de dépôt: 15828494.3
(22) Date de dépôt: 23.12.2015
(51) Int. Cl.: B81B 7/00, H01P 1/12

(54) **MEMS RF CAPACITIF DESTINE A DES APPLICATIONS DE FORTE PUISSANCE.**
KAPAZITIVES RF-MEMS FÜR HOCHLEISTUNGSANWENDUNGEN
CAPACITIVE RF MEMS INTENDED FOR HIGH-POWER APPLICATIONS

(30) Priorité: 23.12.2014 FR 1402972
(43) Date de publication de la demande: 01.11.2017
(73) Titulaire: THALES, 92400 Courbevoie (FR)
(72) Inventeur: ZIAEI, Afshin, 91767 Palaiseau (FR); LE BAILLIF, Matthieu, 91767 Palaiseau (FR); MARTINS, Paolo, 91767 Palaiseau (FR); BANSROPUN, Shailendra, 91767 Palaiseau (FR)
(74) Mandataire: Marks & Clerk France
(86) Numéro de dépôt international: PCT/EP2015/081127
(87) Numéro de publication internationale: WO 2016/102650

(56) Documents cités:
- EP-A2- 0 709 911
- WO-A1-2014/165624
- FR-A1- 2 930 370
- JP-A- 2003 340 795
- US-A1- 2005 242 687

## Description

Le domaine de l'invention est celui des micro-interrupteurs encore dénommés « commutateurs » réalisés en technologie microsystème électromécanique ou MEMS, l'acronyme MEMS signifiant « Micro Electro Mechanical System » en langue anglaise.

Le domaine privilégié d'application concerne les systèmes de radiofréquences, et, plus précisément, les applications dans le domaine des radars, et notamment, les radars utilisant des fréquences comprises entre 8 et 12 GHz. Les composants MEMS proposés peuvent toutefois trouver des applications dans des domaines de fréquences très élevées de l'ordre de 150 GHz.

Le principe de fonctionnement des composants MEMS est le suivant.

Au moyen d'une électrode de commande, on exerce une force électrostatique sur un objet mécanique de très faibles dimensions disposé au voisinage d'une ligne de transmission de radiofréquences. Le déplacement ou la déformation de l'objet soumis à cette force fait varier un paramètre électronique qui est le plus souvent une résistance ou une capacité. Cette variation interrompt ou rétablit la transmission des radiofréquences dans la ligne de transmission. Une réalisation de ce type de commutateur est divulguée dans FR2930370 ou encore WO2014/165624.

Pour réaliser un interrupteur de type capacitif, on utilise préférentiellement des dispositifs à « pont » ou à membrane suspendue.

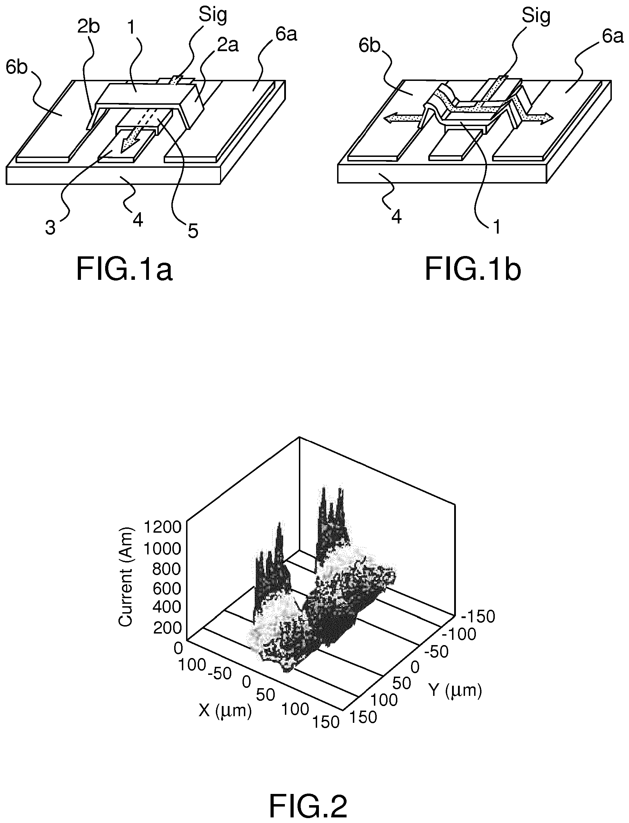

Le principe de fonctionnement de ce type de dispositif est décrit dans le cas le plus simple de l'utilisation en micro-interrupteur, et, est illustré sur les figures 1a et 1b qui représentent respectivement un état dit « haut » dans lequel le signal passe et un état dit « bas » dans lequel le signal est court-circuité.

Plus précisément, une membrane ou une poutre métallique 1 de faible épaisseur, de l'ordre de 1 µm, est maintenue suspendue par des piliers 2a, 2b au dessus d'une ligne de transmission de radiofréquences 3 réalisée à la surface d'un substrat 4 dans laquelle un signal Sig est propagé.

Une couche diélectrique 5 est déposée sur la surface de la ligne de transmission 3. Des lignes conductrices 6a, 6b, encore appelées plans de masse 6a ; 6b, sont connectées à la ligne de transmission 3 et sont reliées à la masse M, non visible sur les figures 1a et 1b.

La membrane 1 peut être soumise à une tension électrique au moyen d'une électrode de commande.

En l'absence de tension appliquée, la membrane 1 est suspendue au-dessus de la ligne de transmission 3 à une première hauteur ou à un premier « gap » pouvant être assimilé à une première capacité, typiquement la première hauteur est supérieure à 1 micron.

Lorsque l'on applique une tension électrique suffisamment élevée sur l'électrode de commande, la membrane 1 est soumise à une force électrostatique qui la déforme. La membrane 1 est alors séparée de la ligne de transmission 3 par une couche de diélectrique 5 formant une deuxième capacité qui est très supérieure à la première capacité formée par le premier gap d'air. Par conséquent, les radiofréquences sont court-circuitées vers la masse M.

Selon le montage électronique, la variation de cette capacité peut être utilisée pour réaliser un micro-interrupteur.

Plusieurs études ont montré que lorsque la membrane d'un MEMS RF est à l'état bas, ou, en d'autres termes, lorsque le signal RF est court-circuité vers la masse M, des courants électriques relativement importants circulent dans la membrane 1.

La figure 2 est une représentation graphique d'une simulation des densités de courant généré dans la membrane 1 en fonction de la région de la membrane 1 considérée lorsque celle-ci est à l'état bas, ou, en d'autres termes, lorsque le signal Sig est shunté ou dérivé vers la masse M.

La membrane 1 est définie selon deux axes : un premier axe Ox est de direction parallèle à la direction de propagation du signal Sig dans la ligne de transmission 3, et, un deuxième axe Oy est de direction perpendiculaire à la direction de propagation du signal Sig dans la ligne de transmission 3.

Selon la direction de l'axe Ox, trois zones successives peuvent être définies :
- une première zone Z1 présentant un fort courant de l'ordre de 800 mA
- une deuxième zone Z2 présentant un courant plus faible que celui observé sur la première zone Z1, les courants mesurés étant de l'ordre de 400 mA
- une troisième zone Z3 présentant des courants quasiment nuls.

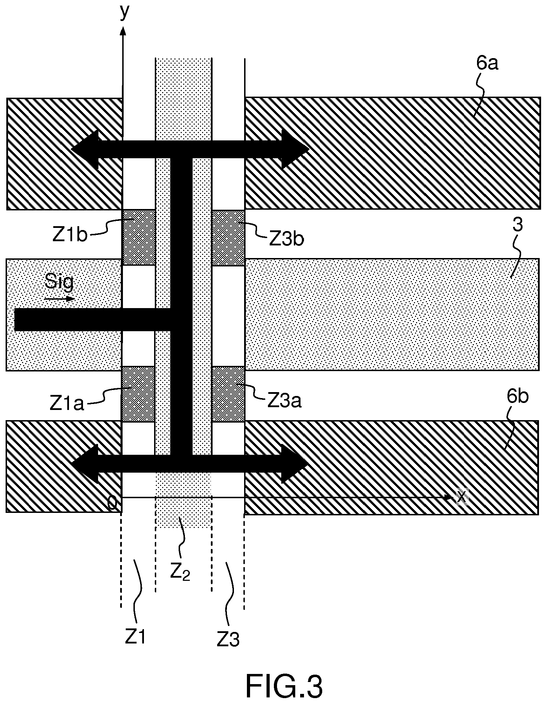

La figure 3 est une représentation schématique d'une membrane 1 dans laquelle circule un signal Sig lorsque la membrane 1 est à l'état bas.

Le passage du signal Sig génère une différence de potentiel entre les parties de la membrane 1 en vis-à-vis de la ligne de transmission RF 3 et les parties de la membrane 1 en vis-à-vis des plans de masse 6a ; 6b.

Il se crée alors dans les parties de la membrane 1 qui relient la ligne de transmission 3 aux plans de masse 6a ; 6b une densité de courant générant une augmentation de la température localisée. On peut ainsi définir quatre zones Z1a, Z1b, Z3a et Z3b correspondant aux bordures des parties de la membrane 1 qui relient la ligne de transmission 3 aux plans de masse 6a ; 6b lorsque la membrane 1 est à l'état bas.

Les densités de courants générés sont dépendantes de la fréquence appliquée. Pour des fréquences de l'ordre de la dizaine de gigahertz, les courants sont estimés entre 0,5 à 1A.

De manière similaire, ces zones de plus forte densité de courant sont observables lorsque la membrane est à l'état haut, ou, en d'autres termes, lorsque le signal passe. Toutefois les différences de densités de courant entre les zones de fortes densités et de faibles densités de courant sont moins importantes.

Généralement, les composants MEMS-RF sont soumis à une tension de l'ordre de 10V pour permettre une commutation. Dans ces conditions d'utilisation, les élévations de température dues à la circulation du courant dans la membrane 1 ne risquent pas d'endommager la membrane 1.

Par contre, lorsque l'on augmente la puissance du signal Sig ou la tension électrique de l'ordre de 30 à 50 V ou la fréquence du signal Sig, la circulation du courant dans la membrane 1, lorsque celle-ci est à l'état bas, notamment, provoque une augmentation importante de la température de la membrane 1, et, particulièrement dans les zones Z1a, Z1b, Z3a et Z3b dans lesquelles de fortes densités de courants sont observées, typiquement les bordures de la membrane 1 situées de part et d'autres de la ligne de transmission 3, ou en d'autres termes, en vis-à-vis de la partie du substrat 4 en contact direct avec l'air du gap d'air ou sur les parties de la membrane qui relient la ligne de transmission 3 aux plans de masse 6a ; 6b.

L'application d'une forte puissance, typiquement supérieure ou égale à 15W, sur des MEMS-RF risque de faire brûler la membrane 1 et provoquer une défaillance immédiate du MEMS-RF capacitif.

Un but de l'invention est de proposer un MEMS RF capacitif dans lequel la membrane 1 est capable de résister à de fortes puissances ou une haute fréquence.

Selon un aspect de l'invention, il est proposé un Microsystème ElectroMécanique radiofréquence capacitif ou MEMS RF capacitif comprenant une membrane métallique suspendue au-dessus d'une ligne de transmission RF et reposant sur des plans de masse, et présentant une face inférieure, une face supérieure opposée à la face inférieure et une première couche comprenant un matériau métallique réfractaire recouvrant au moins partiellement la face supérieure de la membrane de manière à empêcher l'échauffement de la membrane.

Avantageusement, l'épaisseur de la première couche est comprise entre 1 et 3 microns.

Préférentiellement, la première couche de matériau réfractaire est disposée sur des parties de la face supérieure de la membrane qui relient la ligne de transmission RF aux plans de masse, ou, en d'autres termes, sur la face supérieure de la membrane en vis-à-vis d'une partie du substrat en contact direct avec l'air du gap d'air.

Préférentiellement, la première couche est disposée sur les bordures des parties de la face supérieure de la membrane qui relient la ligne de transmission RF aux plans de masse ou en d'autres termes des parties de la membrane situées en vis-à-vis d'une partie du substrat en contact direct avec l'air du gap d'air.

Selon un autre aspect de l'invention, la première couche de matériau métallique réfractaire recouvre la totalité de la face supérieure de la membrane et une deuxième couche recouvre la totalité de la face inférieure de la membrane, les coefficients d'élongation thermique de la première et de la deuxième couche se compensent de manière à contenir les déformations de la membrane.

Avantageusement, la première couche et la deuxième couche sont identiques.

Avantageusement, l'épaisseur de la première couche et de la deuxième couche est inférieure ou égale à 200 nm.

Dans l'état de l'art des microsystèmes, on peut citer FR 2 930 370 qui divulgue une membrane réalisée en matériaux composites sur laquelle est agencée une couche de matériau réfractaire et EP 0 709 911 qui divulgue soit une poutre comportant une couche de métal soit comportant deux couches, l'une diélectrique et l'autre métallique. WO2014/165624 divulgue une membrane en matériau réfractaire sur laquelle est agencée une plaque rigide.

L'invention sera mieux comprise et d'autres avantages apparaîtront à la lecture de la description qui va suivre donnée à titre non limitatif, et, grâce aux figures annexées parmi lesquelles :
- les figures 1a et 1b, déjà décrites, illustrent un micro-commutateur de ligne RF à l'état haut et à l'état bas, respectivement, selon l'art connu,
- la figure 2, déjà décrite, est une représentation graphique des densités de courant généré dans la membrane lorsque celle-ci est à l'état bas en fonction de la zone de la membrane considérée,
- la figure 3, déjà décrite, est une représentation schématique de la membrane mettant en évidence les zones présentant une forte densité de courant,
- la figure 4 représente une vue de profil d'un MEMS RF selon un premier mode de réalisation de l'invention,
- la figure 5 représente une vue de dessus d'un MEMS RF selon le premier mode de réalisation de l'invention, et
- la figure 6 représente une vue de profil d'un MEMS RF selon un deuxième mode de réalisation de l'invention.

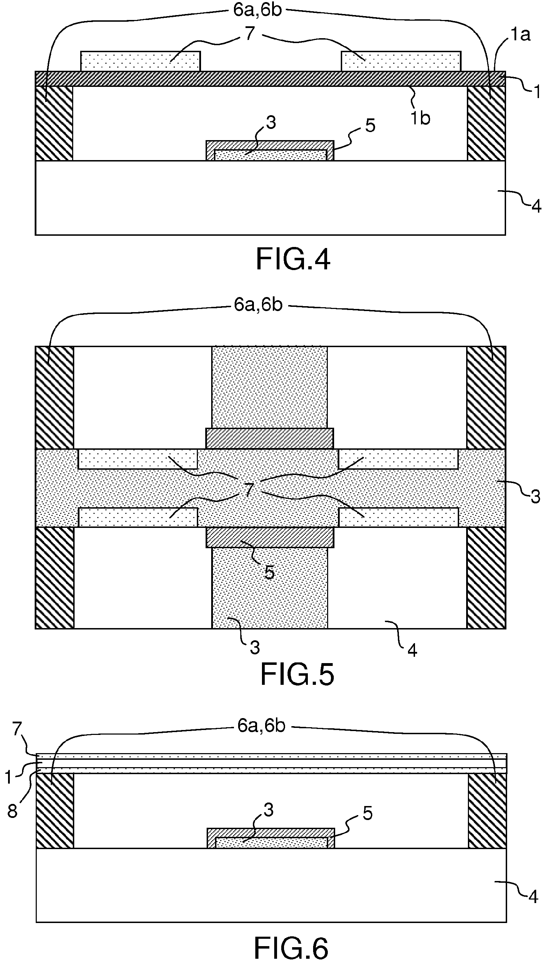

La figure 4 représente une vue de profil d'un MEMS-RF selon un premier mode de réalisation de l'invention.

Une membrane 1 comprenant généralement de l'or ou du cuivre et de faible épaisseur, de l'ordre de 1 µm, est maintenue suspendue sur des lignes de masse 6a ; 6b au dessus d'une ligne de transmission 3 de radiofréquences dans laquelle un signal Sig est propagé, la ligne de transmission 3 est réalisée à la surface d'un substrat 4. En l'espèce, la hauteur du gap d'air ou première hauteur entre le substrat 4 et la membrane 1 est de l'ordre du micron.

En outre, la face supérieure 1a de la membrane 1 est partiellement recouverte d'une première couche 7 comprenant un matériau métallique réfractaire, typiquement le matériau métallique réfractaire comprend du molybdène ou du tungstène.

On entend par matériau métallique réfractaire un métal capable d'absorber une charge thermique élevée tout en maintenant sa cohésion physique et mécanique, notamment. Autrement dit, un matériau métallique réfractaire ne se déformera pas sous l'effet de la température.

Préférentiellement, la première couche métallique réfractaire est disposée sur les parties de la membrane 1 disposées directement en vis-à-vis avec une partie du substrat 4, et, plus particulièrement, sur les bordures de la membrane 1 en vis-à-vis du substrat 4 et en contact direct avec l'air du gap d'air. En d'autres termes, la première couche métallique réfractaire est disposée sur des parties de la face supérieure 1a de la membrane 1 qui relient la ligne de transmission RF 3 aux plans de masse 6a ; 6b.

L'épaisseur de la première couche 7 est comprise entre 1 et 3 microns. L'ajout localisé de la première couche 7 de matériau métallique réfractaire à la surface de la membrane 1 permet de diminuer localement la résistance ohmique ce qui engendre une diminution de l'énergie dissipée par effet Joule diminuant ainsi l'échauffement de la membrane 1.

La figure 5 est une vue de dessus de la membrane d'un MEMS RF selon le premier mode de réalisation de l'invention.

La face supérieure 1a de la membrane 1 est recouverte localement d'une première couche 7 de matériau métallique réfractaire Mat 1. La première couche 7 de matériau métallique réfractaire Mat 1 est disposée sur la membrane 1 en vis-à-vis-du substrat 4 en contact direct avec l'air du gap d'air.

En l'espèce, la première couche 7 de matériau métallique réfractaire est disposée sur les bordures de la membrane en vis-à-vis avec le substrat, la largeur des bordures dépendant des fréquences appliquées. On peut toutefois citer comme exemple, une largeur de bordure d'environ 10 microns pour une fréquence de 10GHz.

Le MEMS RF selon le premier mode de réalisation de l'invention permet un renforcement de la membrane 1 tout en limitant localement l'augmentation de la température générée par la circulation du courant dans la membrane 1.

Le MEMS RF proposé présente un gap d'air de l'ordre du micron, les déformations de la membrane 1 engendrées localement par les variations de température en fonction de la région de la membrane 1 ont peu d'incidences sur la fiabilité du MEMS RF.

Par contre, pour des applications nécessitant un temps de commutation très court, il est nécessaire de réaliser un MEMS RF dans lequel le gap d'air est submicronique, typiquement 500 nm. Les déformations locales de la membrane 1 engendrées par des différences de températures d'une région à l'autre de la membrane1 génèrent des dysfonctionnements du MEMS RF.

En effet, sous l'effet de l'augmentation de température, la membrane 1 comprenant généralement de l'or ou du cuivre, très bon conducteur électrique, se ramollit et se déforme, la hauteur du gap d'air n'est pas constante sur toute la surface de la membrane 1.

Le deuxième mode de réalisation des MEMS RF selon l'invention permet la réalisation de MEMS RF à faible gap d'air, typiquement de l'ordre de 500 nm, pouvant supporter de forte puissance, supérieure ou égale à 15W.

La figure 6 représente un deuxième mode de réalisation de l'invention. Le MEMS RF comprend une membrane 1 de faible épaisseur, de l'ordre de 500 nm, maintenue suspendue sur des lignes de masse 6a ; 6b au dessus d'une ligne de transmission 3 dans laquelle un signal Sig est propagé. Le gap d'air est de l'ordre de 500 nm ce qui autorise un temps de commutation court inférieur à la microseconde.

La membrane 1 comprenant un matériau métallique, généralement de l'or ou du cuivre, est entièrement recouverte sur sa face supérieure par une première couche 7 de matériau métallique réfractaire, comme du molybdène ou du tungstène et sur sa face inférieure par une deuxième couche 8 de matériau réfractaire Mat 2, les coefficients d'élongation thermique de la première 7 et de la deuxième 8 couche se compensant l'un par rapport à l'autre de manière à contenir la membrane 1 et empêcher les déformations locales de la membrane 1 tout en diminuant la résistance ohmique. Avantageusement, la première couche 7 et la deuxième 8 couches ont une épaisseur comprise entre 100 et 200 nm. Préférentiellement, la première 7 et la deuxième 8 couches sont identiques.

Ainsi, la membrane 1 reste sensiblement plane au cours du fonctionnement du MEMS RF. En d'autres termes, la membrane 1 ne se déforme pas, et ne se courbe pas.

Cette plus grande stabilité autorise une utilisation à plus forte puissance des MEMS RF selon l'invention.

Cette plus grande stabilité due à la plus grande raideur de la membrane 1 permet en outre de diminuer le premier gap et d'obtenir un temps de commutation plus faible, la membrane étant plus raide, le risque de court circuit du à une déformation de la membrane 1 est plus faible.

Le MEMS RF ainsi réalisé augmente la raideur de la membrane 1, celle-ci ne se déforme plus sous l'effet de l'élévation de température et évite ainsi les dysfonctionnements du MEMS RF.

## Revendications

1. Microsystème Electromécanique radiofréquence capacitif ou MEMS RF capacitif pour des applications de forte puissance comprenant une membrane (1) suspendue au-dessus d'une ligne de transmission RF (3) et reposant sur des plans de masse (6a ; 6b), la membrane (1) présentant une face inférieure (1b) et une face supérieure (1a) opposée à la face inférieure (1b), le MEMS RF étant **caractérisé en ce que** ladite membrane (1) est métallique et **en ce qu'**une première couche (7) comprenant un matériau métallique réfractaire (Mat1) recouvre au moins partiellement la face supérieure (1a) de la membrane (1) de manière à empêcher l'échauffement de la membrane (1).

2. MEMS RF selon la revendication 1 dans lequel l'épaisseur de la première couche (7) de matériau métallique réfractaire est comprise entre 1 et 3 microns.

3. MEMS RF selon l'une des revendications précédentes dans lequel la première couche de matériau métallique réfractaire (7) est disposée sur les parties de la face supérieure (1a) de la membrane (1) qui relient la ligne de transmission RF (3) aux plans de masse (6a ; 6b) lorsque la membrane (1) est à l'état bas.

4. MEMS RF selon la revendication 3 dans lequel la première couche de matériau réfractaire (7) est disposée sur les bordures des parties de la face supérieure (1a) de la membrane (1) qui relient la ligne de transmission RF (3) aux plans de masse (6a ; 6b) lorsque la membrane (1) est à l'état bas.

5. MEMS RF selon la revendication 1 dans lequel la première couche de matériau métallique réfractaire (7) recouvre la totalité de la face supérieure (1a) de la membrane (1) et une deuxième couche (8) recouvre la totalité de la face inférieure (1b) de la membrane (1), les coefficients d'élongation thermique de la première (7) et de la deuxième (8) couche se compensant de manière à contenir les déformations de la membrane.

6. MEMS RF selon la revendication 5 dans lequel la première couche de matériau métallique réfractaire (7) et la deuxième couche (8) sont identiques.

7. MEMS RF selon les revendications 5 ou 6 dans lequel l'épaisseur de la première (7) et de la deuxième (8) couche est inférieure ou égale à 200 nm.

## Patentansprüche

1. Kapazitives Hochfrequenz-Mikro-Elektromechanisches System oder kapazitives HF-MEMS für Hochleistungsanwendungen, umfassend eine Membran (1), welche oberhalb einer HF-Übertragungsleitung (3) aufgehängt ist und auf Masseebenen (6a; 6b) ruht, wobei die Membran (1) eine untere Seite (1b) und eine der unteren Seite (1b) entgegengesetzte obere Seite (1a) aufweist, wobei das HF-MEMS **dadurch gekennzeichnet ist, dass** die Membran (1) metallisch ist und dadurch, dass eine erste Schicht (7), welche ein hitzebeständiges metallisches Material (Mat1) umfasst, mindestens teilweise die obere Seite (1a) der Membran (1) dergestalt bedeckt, dass sie die Erhitzung der Membran (1) verhindert.

2. HF-MEMS nach Anspruch 1, wobei die Dicke der ersten Schicht (7) aus hitzebeständigem metallischem Material zwischen 1 und 3 Mikrometern umfasst.

3. HF-MEMS nach einem der vorhergehenden Ansprüche, wobei die erste Schicht aus hitzebeständigem metallischem Material (7) auf Teilen der oberen Seite (1a) der Membran (1) angeordnet ist, welche die HF-Übertragungsleitung (3) mit den Masseebenen (6a; 6b) verbindet, wenn die Membran (1) im niedrigen Zustand ist.

4. HF-MEMS nach Anspruch 3, wobei die erste Schicht aus hitzebeständigem Material (7) auf den Rändern der Teile der oberen Seite (1a) der Membran (1) angeordnet ist, welche die HF-Übertragungsleitung (3) mit den Masseebenen (6a; 6b) verbinden, wenn die Membran (1) im niedrigen Zustand ist.

5. HF-MEMS nach Anspruch 1, wobei die erste Schicht aus hitzebeständigem metallischem Material (7) die Gesamtheit der oberen Seite (1a) der Membran (1) bedeckt und eine zweite Schicht (8) die Gesamtheit der unteren Seite (1b) der Membran (1) bedeckt, wobei die Wärmedehnungskoeffizienten der ersten (7) und der zweiten (8) Schicht einander dergestalt kompensieren, dass die Verformungen der Membran eingedämmt werden.

6. HF-MEMS nach Anspruch 5, wobei die erste Schicht aus hitzebeständigem metallischem Material (7) und die zweite Schicht (8) identisch sind.

7. HF-MEMS nach den Ansprüchen 5 oder 6, wobei die Dicke der ersten (7) und der zweiten (8) Schicht kleiner oder gleich 200 nm ist.

## Claims

1. A capacitive radiofrequency micro-electromechanical system or capacitive RF MEMS for high-power applications comprising a membrane (1) suspended above an RF transmission line (3) and resting on ground planes (6a; 6b), the membrane (1) exhibiting a lower face (1b) and an upper face (1a) opposite to the lower face (1b), the RF MEMS being **characterised in that** said membrane (1) is metallic and **in that** a first layer (7) comprising a refractory metallic material (Mat1) at least partially covers the upper face (1a) of the membrane (1) so as to prevent the heating of the membrane (1).

2. The RF MEMS as claimed in claim 1, wherein the thickness of the first layer (7) of refractory metallic material is between 1 and 3 microns.

3. The RF MEMS as claimed in one of the preceding claims, wherein the first layer (7) of refractory metallic material is disposed on the parts of the upper face (1a) of the membrane (1) which link the RF transmission line (3) to the ground planes (6a; 6b) when the membrane (1) is in the low state.

4. The RF MEMS according to claim 3, wherein the first layer of refractory metallic material (7) is disposed on the boundaries of the parts of the upper face (1a) of the membrane (1) which link the RF transmission line (3) to the ground planes (6a; 6b) when the membrane (1) is in the low state.

5. The RF MEMS according to claim 1, wherein the first layer (7) of refractory metallic material covers the totality of the upper face (1a) of the membrane (1) and a second layer (8) covers the totality of the lower face (1b) of the membrane (1), the coefficients of thermal elongation of the first (7) and of the second (8) layer compensating one another so as to contain the deformations of the membrane.

6. The RF MEMS according to claim 5, wherein the first layer (7) of refractory metallic material and the second layer (8) are identical.

7. The RF MEMS according to claims 5 or 6, wherein the thickness of the first (7) and of the second (8) layer is less than or equal to 200 nm.
